# EUROPÄISCHE PATENTSCHRIFT

(11) **EP 1 202 041 B1**
(45) Veröffentlichungstag und Bekanntmachung des Hinweises auf die Patenterteilung: **18.03.2009**
(21) Anmeldenummer: 00123729.6
(22) Anmeldetag: 31.10.2000
(51) Int. Cl.: G01M 19/00, G07C 3/00, G05D 23/00

(54) **Verfahren und Vorrichtung zur Belastungsprüfung von elektrischen Systemen eines Kraftfahrzeugs**
Procedure and device for endurance testing of electrical systems of a vehicle
Procédé et dispositif d'essai d'endurance de systèmes électriques de véhicule

(43) Veröffentlichungstag der Anmeldung: 02.05.2002
(73) Patentinhaber: Ford Global Technologies, LLC, Dearborn, MI 48126 (US)
(72) Erfinder: Freese, Holm, 40595 Düsseldorf (DE); Sigwart, Andreas, Dr., 42499 Hückeswagen (DE); Bockemühl, Peter, 51515 Kürten-Bechen (DE); Richarz, Karl-Heinz, 53227 Bonn (DE)
(74) Vertreter: Bonsmann, Manfred

(56) Entgegenhaltungen:
- DE-A- 3 105 491
- DE-A- 4 240 756
- DE-A- 4 305 901
- "EIN 3000ER IM LABOR" ELEKTROTECHNIK., Bd. 65, Nr. 7, April 1983 (1983-04), Seite 14 XP002164349 VOGEL VERLAG K.G. WURZBURG. 331951 1, DE ISSN: 1431-9578

## Beschreibung

Die Erfindung betrifft ein Verfahren zur Belastungsprüfung von elektrischen Systemen eines Kraftfahrzeugs, wobei die Bedienelemente der Systeme durch mindestens eine automatische Betätigungsvorrichtung testweise betätigt werden. Ferner betrifft die Erfindung eine Vorrichtung zur Durchführung des genannten Verfahrens.

In Kraftfahrzeugen finden zunehmend elektrische und elektronische Systeme wachsender Komplexität Verwendung. Aus diesem Grunde kommt einer Belastungsprüfung solcher elektrischen Systeme - worunter im Folgenden auch elektronische Systeme verstanden werden sollen - eine besondere Bedeutung zu. Durch eine Belastungsprüfung soll festgestellt werden, ob die Systeme eine ausreichend hohe Lebensdauer und Funktionstüchtigkeit aufweisen. Dabei sind speziell die Bedienelemente der elektrischen Systeme einer Prüfung zu unterziehen, da diese einer hohen mechanischen Belastung ausgesetzt sind und somit vorrangig einem Verschleiß und Ausfallerscheinungen unterliegen.

Aus der DE 31 05 491 C2 ist diesbezüglich eine Lebensdauer-Prüfvorrichtung für elektromechanische Bauelemente von Kraftfahrzeugen bekannt, bei welcher in einem Versuchsaufbau über Schrittmotoren eine wiederholte Betätigung eines Schalters vorgenommen werden kann. Gleichzeitig können entsprechende Daten über die hierbei auftretenden Kräfte und Momente aufgezeichnet werden. Eine solche Vorrichtung erlaubt die Prüfung eines Schalters hinsichtlich seines Verhaltens bei vielfach wiederholter Betätigung. Es zeigt sich jedoch, dass die hieraus gewonnenen Ergebnisse für eine Beurteilung des Schalterverhaltens unter realen Bedingungen nicht ausreichen. So kommt es bei der Verwendung der elektrischen Systeme einschließlich der Bedienelemente in einem Kraftfahrzeug unter realen Bedingungen zu zahlreichen und komplexen Wechselwirkungen der Systeme untereinander sowie zu großen Variationen der Belastungen aufgrund von realen Umgebungsbedingungen.

Vor diesem Hintergrund war es Aufgabe der vorliegenden Erfindung, ein Verfahren und eine Vorrichtung zur Belastungsprüfung von elektrischen Systemen eines Kraftfahrzeuges bereitzustellen, welche eine bessere Beurteilung des Verhaltens und der Belastungen unter realen Bedingungen ermöglichen.

Diese Aufgabe wird durch ein Verfahren mit den Merkmalen des Anspruchs 1 sowie eine Vorrichtung mit den Merkmalen des Anspruchs 9 gelöst. Vorteilhafte Ausgestaltungen sind in den Unteransprüchen enthalten.

Bei dem Verfahren zur Belastungsprüfung von elektrischen (einschließlich elektronischen) Systemen eines Kraftfahrzeuges werden die Bedienelemente der Systeme durch mindestens eine automatische Betätigungsvorrichtung zu Prüfzwekken wiederholt betätigt. Das Verfahren ist **dadurch gekennzeichnet, dass** die elektrischen Systeme in ihrem eingebauten, betriebsbereiten Zustand in einem Kraftfahrzeug geprüft werden, und dass das Kraftfahrzeug während dieser Prüfung einer Simulation von realen Umgebungsbedingungen ausgesetzt ist.

Durch das erfindungsgemäße Verfahren wird eine erheblich bessere Annäherung an die realen Benutzungsbedingungen der elektrischen Systeme erzielt. Dies geschieht dadurch, dass die elektrischen Systeme beziehungsweise die zugehörigen Bedienelemente nicht isoliert in einem künstlichen Aufbau getestet werden, sondern dass sie sich in ihrem endgültigen Einbauzustand im Kraftfahrzeug befinden. Hierdurch werden einerseits Wechselwirkungen der elektrischen Systeme untereinander als auch Wechselwirkungen zwischen einem elektrischen System beziehungsweise einem Bedienelement und dem Kraftfahrzeug berücksichtigt. So kann zum Beispiel das Verhalten eines Schalters je nach Einbauort und Einbauart sehr unterschiedlich ausfallen, wobei durch das vorgeschlagene Verfahren sichergestellt ist, dass der Prüfung die tatsächlichen Einbauumstände zugrunde gelegt werden.

Eine weitere wesentliche Verbesserung der Testergebnisse wird dadurch erreicht, dass das Kraftfahrzeug während der Prüfung einer Simulation von realen Umgebungsbedingungen ausgesetzt ist, die ebenfalls erheblichen Einfluss auf das Verhalten der Systeme und Bedienelemente haben können.

Dabei kann zu den simulierten Umgebungsbedingungen insbesondere die Umgebungstemperatur gehören. Diese wird während der Prüfung in einem Bereich variiert, welcher den Temperaturen entspricht, die beim realen Einsatz des Kraftfahrzeugs auftreten können. Typischerweise liegt dieser Temperaturbereich zwischen -40°C und +85°C. Die Verteilung der Prüfungszeit über die Temperaturen kann basierend auf der realen Temperaturverteilung gewählt werden, welcher ein Kraftfahrzeug typischerweise während seiner Lebensdauer ausgesetzt ist. Vorzugsweise werden jedoch Extremtemperaturen bei der Prüfung überproportional zugrunde gelegt, da sich diese besonders belastend auswirken und somit bei der Feststellung der Belastbarkeitsgrenze von höherer Bedeutung sind.

Weiterhin kann zu den simulierten Umgebungsbedingungen die Luftfeuchtigkeit gehören, da auch diese einen erheblichen Einfluss auf das Belastungsverhalten der zu prüfenden Systeme beziehungsweise Bedienelemente hat. Die Luftfeuchtigkeit wird vorzugsweise während des Tests in dem unter realen Bedingungen auftretenden Schwankungsbereich variiert.

Zu den simulierten Umgebungsbedingungen kann auch die Sonneneinstrahlung gehören, die vorzugsweise durch eine künstliche Bestrahlung mit Licht einer geeigneten Wellenlängenverteilung (Spektrum) und mit einer Leistung von typischerweise 4000 W/m² simuliert wird.

Schließlich können zu den simulierten Umgebungsbedingungen auch solche Beschleunigungen des Kraftfahrzeugs gehören, die unter realen Bedingungen typischerweise auftreten. Insbesondere hochfrequente Beschleunigungen (Stöße) haben verständlicherweise erheblichen Einfluss auf das mechanische Verhalten der zu prüfenden Systeme und Bedienelemente. Ferner sind vor allem Beschleunigungen in vertikaler Richtung von Interesse, welche durch eine vertikale Bewegung der Standflächen der Räder simuliert werden können. Dabei sollten vorzugsweise die Standflächen unter den Rädern der Vorderachse unabhängig von den Standflächen unter den Rädern der Hinterachse bewegt werden können. Besonders bevorzugt ist es, dass alle Standflächen der Räder unabhängig voneinander angesteuert und bewegt werden können. Das dem Kraftfahrzeug aufgeprägte Beschleunigungsprogramm kann durch bei einer realen Fahrt aufgezeichnete Beschleunigungen vorgegeben werden, um so eine besonders realistische Simulation zu gewährleisten.

Zur automatischen Betätigung der Bedienelemente wird vorzugsweise ein Roboter verwendet. Ein solcher Roboter hat den Vorteil, dass mit ihm flexibel auch komplexe Bedienvorgänge und Abfolgen von Betätigungen verschiedener Bedienelemente vorgenommen werden können, wobei die Bewegungsabläufe zum Beispiel durch ein Teach-in vorgegeben werden können. Der Einsatz eines Roboters hat ferner den Vorteil, dass er hinsichtlich der Kraftaufbringung und der Bewegungsabfolge den Verhältnissen bei einer Betätigung der Bedienelemente durch einen Fahrer besonders nahe kommt.

Während der Betätigung der Bedienelemente werden vorzugsweise die hierbei auftretenden Kräfte und Drehmomente durch die Betätigungsvorrichtung sensorisch erfasst. Die so gewonnen Daten können dann später oder gleichzeitig (online) mit geeigneten Analyseverfahren ausgewertet werden und geben wertvolle Hinweise über Verhalten und Veränderungen der Bedienelemente.

Die Betätigung der Bedienelemente der elektrischen Systeme wird vorteilhafterweise so ausgeführt, dass die dabei auftretenden Kräfte und Drehmomente hinsichtlich ihrer Größe und ihrer Richtung variieren. Auch hierdurch wird eine größere Realitätsnähe der Belastungsprüfung erreicht, da die Betätigung solcher Bedienelemente durch einen Menschen immer gewissen Variationen unterworfen ist. Insbesondere können auch suboptimale beziehungsweise nicht korrekte Betätigungen durchgeführt werden, um auch deren Einfluss zu erfassen.

Die Erfindung betrifft ferner eine Vorrichtung zur Belastungsprüfung von elektrischen (einschließlich elektronischen) Systemen eines Kraftfahrzeugs, welche eine automatische Betätigungsvorrichtung zur Betätigung der Bedienelemente der Systeme aufweist. Die Vorrichtung ist **dadurch gekennzeichnet, dass** sie eine Simulationskammer enthält, in welche ein die zu prüfenden Systeme enthaltendes Kraftfahrzeug eingebracht werden kann, und in welcher Umgebungsbedingungen für das gesamte Kraftfahrzeug simuliert werden können. Weiterhin ist die automatische Betätigungsvorrichtung so ausgestaltet, dass sie im Betriebszustand innerhalb eines Kraftfahrzeugs mit den zu prüfenden Systemen angeordnet werden kann.

Die genannte Vorrichtung erlaubt die Durchführung des oben erläuterten Verfahrens, so dass sich die dort geschilderten Vorteile erzielen lassen. Insbesondere wird eine größere Realitätsnähe der Belastungsprüfung durch das Testen der Systeme im eingebauten Zustand in einem Kraftfahrzeug und unter (simulierten) Umgebungsbedingungen erreicht.

Die Simulationskammer kann insbesondere eine Klimaanlage aufweisen, mit welcher sich reale Klimabedingungen hinsichtlich Temperatur, Luftfeuchtigkeit und dergleichen simulieren lassen.

Ferner kann die Simulationskammer Strahler zur Abgabe elektromagnetischer Strahlung eines geeigneten Spektrums aufweisen, um hierdurch die Einwirkung von Sonneneinstrahlung zu simulieren.

Des weiteren enthält die Simulationskammer vorzugsweise einen sogenannten Straßensimulator zur Simulation von Beschleunigungen, die auf ein Kraftfahrzeug während einer Fahrt einwirken. Der Straßensimulator kann insbesondere aus Standflächen für die Räder eines Kraftfahrzeugs gebildet werden, welche über eine Ansteuerung separat in vertikaler Richtung bewegt werden können.

Die Betätigungsvorrichtung enthält ferner vorteilhafterweise Sensoren, mit welchen die Kräfte und Drehmomente erfasst werden können, die bei der Betätigung von Bedienelementen der elektrischen Systeme auftreten. Die Signale dieser Sensoren können aufgezeichnet oder in Echtzeit ausgewertet werden, um hieraus wichtige Rückschlüsse über das Verhalten der Bedienelemente zu ziehen.

Bei der Betätigungsvorrichtung handelt es sich vorzugsweise um einen Roboter. Ein solcher Roboter hat den Vorteil, dass mit ihm flexibel auch komplexe Bedienvorgänge und Abfolgen von Betätigungen verschiedener Bedienelemente vorgenommen werden können, wobei die Bewegungsabläufe zum Beispiel durch ein Teach-in vorgegeben werden können. Der Einsatz eines Roboters hat ferner den Vorteil, dass er hinsichtlich der Kraftaufbringung und der Bewegungsabfolge den Verhältnissen bei einer Betätigung der Bedienelemente durch einen Fahrer besonders nahe kommt.

Der Roboter wird vorteilhafterweise mit einer Schutzumhüllung versehen, deren Innenraum klimatisierbar ist. Auf diese Weise kann sichergestellt werden, dass der Roboter unabhängig von den um ihn herum herrschenden (simulierten) Umgebungsbedingungen zuverlässig arbeitet.

Im Folgenden wird die Erfindung mit Hilfe der Figuren beispielhaft näher erläutert. Es zeigen:
- Fig. 1: schematisch die Komponenten einer erfindungsgemäßen Vorrichtung zur Belastungsprüfung;
- Fig. 2: den detaillierteren Aufbau der Vorrichtung nach Figur 1;
- Fig. 3: ein Kraft-Weg-Diagramm für ein typisches Bedienelement;
- Fig. 4: einen Betätigungsplan für verschiedene Bedienelemente;
- Fig. 5: die Zeitsteuerung einer Vibrations-Simulation;
- Fig. 6: die Zeitsteuerung der Umgebungstemperatur-Simulation;
- Fig. 7: die Häufigkeitsverteilung der simulierten Temperaturen;
- Fig. 8: ein Flussdiagramm des Prüfverfahrens.

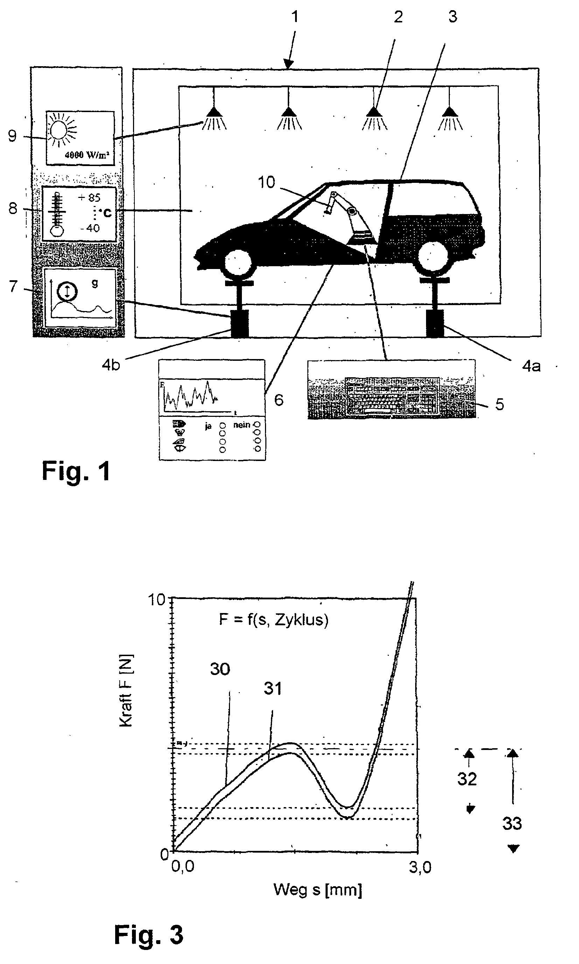

Figur 1 zeigt schematisch die erfindungsgemäße Vorrichtung zur Durchführung einer Belastungsprüfung an elektrischen Systemen eines Kraftfahrzeugs 3. Die elektrischen Systeme beziehungsweise ihre Bedienelemente wie z.B. Drehschalter, Kippschalter, Schieber, etc. werden dabei im eingebauten Zustand im Kraftfahrzeug 3 getestet.

Das Kraftfahrzeug 3 befindet sich zu diesem Zweck in einer Simulationskammer 1, in welcher reale Umgebungsbedingungen für das gesamte Kraftfahrzeug 3 simuliert werden können. Insbesondere lässt sich über an der Decke der Simulationskammer angebrachte Strahler 2 die Sonneneinstrahlung 9 mit einem Wert von typischerweise 4000 W/m² simulieren. Über eine Klimaanlage 8 können die Umgebungstemperatur und die Luftfeuchtigkeit nach einem vorgegebenen Programm simuliert werden. Weiterhin ist in der Simulationskammer 1 ein vierkanaliger Straßensimulator 7 vorgesehen, welcher unabhängig voneinander vertikal bewegbare Standflächen 4a, 4b für die Räder des Kraftfahrzeugs enthält. Durch diesen Straßensimulator können Vertikalbeschleunigungen simuliert werden, die bei einer typischen Fahrt des Kraftfahrzeugs 3 auftreten. Das Programm der Beschleunigungen kann z.B. aus einer Messung bei einer realen Fahrt stammen.

Zur Betätigung der Bedienelemente der elektrischen Systeme ist im Kraftfahrzeug ein Roboter 10 vorgesehen. Dieser ist vorteilhafterweise auf der Position des Fahrersitzes angeordnet, so dass hinsichtlich der Kraftaufbringung möglichst realistische Verhältnisse eintreten. Die Bewegung des Roboters 10 wird von einer Steuervorrichtung 5 nach einem vorgebbaren Programm ausgeführt. Durch den Roboter 10 ist es möglich, auch komplexe Betätigungsvorgänge von verschiedenen Bedienelementen hintereinander durchzuführen. Auf diese Weise lassen sich realistische Wechselwirkungen zwischen den elektrischen Systemen simulieren. Der Roboter 10 kann mit einem starren Greifer als Betätigungsorgan ausgestattet sein, möglich ist jedoch auch die Anbringung eines pneumatischen Greifers, der zusätzliche Freiheitsgrade erlaubt. Insbesondere kann der Roboterarm bionisch ausgebildet sein, also eine kraftkontrollierte Betätigung der Kippschalter oder Drehschalter ermöglichen.

Der Roboter 10 ist vorzugsweise mit Sensoren ausgerüstet, welche die Kräfte und Drehmomente messen, die bei der Betätigung eines Bedienelementes auftreten. Diese Kräfte und Momente lassen sich über die Signalleitung 6 auslesen und für eine Analyse aufzeichnen.

Mit der erfindungsgemäßen Simulationskammer 1 und dem Roboter 10 kann somit eine Dauerfestigkeitsprüfung der Elektronik erfolgen, bei welcher auch extreme klimatische Bedingungen berücksichtigt werden können. Auf diese Weise wird die Zuverlässigkeit und Betriebsfestigkeit von Komponenten und Systemen gewissermaßen im Zeitraffer bei typischen Laufzeiten von 10 Jahren und 277.800 km (150 000 Meilen) geprüft. Mit der Vorrichtung können in einem integrierten Testzyklus die Straßenverhältnisse und die klimatischen Bedingungen simuliert und zugleich die elektrischen Komponenten betätigt werden. Damit nähern sich die Laborbedingungen weiter an die Realität an, und zusätzlich wird für die notwendigen Tests Zeit gespart.

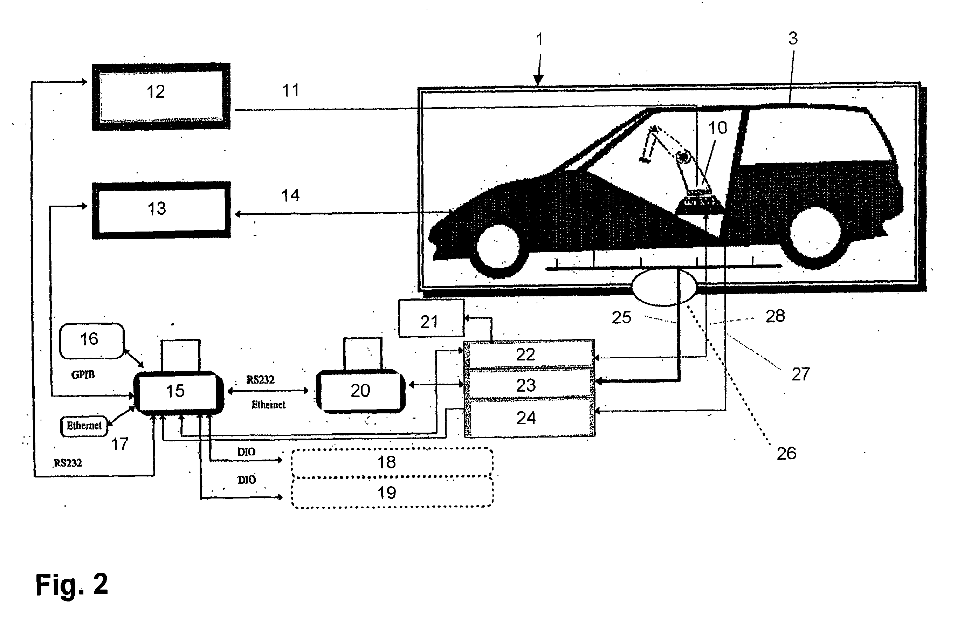

Figur 2 zeigt detaillierter die verschiedenen Komponenten der Prüfvorrichtung von Figur 1. Gleiche Teile wie bei Figur 1 sind dabei mit den gleichen Bezugsziffern versehen.

Das Kraftfahrzeug 3 mit den zu testenden Systemen befindet sich in einer Klimakammer 1 für ein komplettes Fahrzeug, in welcher Temperaturen zwischen -40°C und +85°C in beliebigen Verläufen erzeugt werden können und auch die extreme Sonneneinstrahlung simuliert werden kann. Über einen vierkanaligen Straßensimulator können zugleich fahrbahntypische Schwingungen erzeugt werden.

Die weiteren in Figur 2 gezeigten Komponenten dienen insbesondere dem Betrieb des Roboters 10, durch welchen die Bedienelemente der elektrischen Systeme im Kraftfahrzeug betätigt werden. Der Roboter 10 ist dabei mit einer Schutzumhüllung versehen, so dass er zuverlässig bei allen in der Simulationskammer 1 auftretenden Temperaturen arbeiten kann. Die klimatisierte Schutzumhüllung des Roboters 10 ist am Roboterfuß über Röhren 11 für ein spezielles Kühlungs- und Heizungsfluid mit einem mobilen Klimagerät 12 außerhalb der Klimakammer 1 verbunden. Das Klimagerät 12 wird über Temperaturfühler im Inneren der Schutzhülle gesteuert und erzeugt je nach Temperatur in der Klimakammer 1 warme beziehungsweise kalte Luft, die in die Schutzhülle geführt wird. Die Temperatur in der Schutzhülle kann so unabhängig von Umgebungstemperaturen (-40°C bis +85°C) in einem erlaubten Temperaturbereich von ca. 5°C bis 35°C gehalten werden. Temperatur- und Strömungssensoren überwachen den Innenraum der Schutzhülle und geben Meldungen aus, wenn Unregelmäßigkeiten auftreten.

Das Klimagerät 12 wird von einer computerbasierten Roboterregelung 15 gesteuert. Diese Computersteuerung 15 steuert ferner eine Energieversorgung 13 für den Roboter, welche über eine Spannungsleitung 14 von 8 bis 18 V mit dem Roboter verbunden ist.

Weiterhin ist die Computersteuerung 15 über digitale Schnittstellen mit einer Steuerung 18 der Klimakammer (Weiss) sowie einer Einrichtung 19 zur Erzeugung von Hydroimpulsen verbunden. Eine weitere Verbindung der Computersteuerung 15 besteht zu einer PC-basierten Datenerfassung 20, wobei die genannte Verbindung über eine parallele Schnittstelle (RS 232) oder ein Ethernet gebildet werden kann. Mit der Datenerfassung 20 können alle elektrischen Systeme während der Prüfung vermessen und beobachtet werden, um die logischen Funktionen, Spannungen und Ströme in Echtzeit darzustellen und eine Verschlechterung durch Einflüsse wie zum Beispiel Verschleiß zu visualisieren.

Zur unmittelbaren Ansteuerung und Kommunikation mit dem Roboter 10 sind die Module 22, 23 und 24 vorgesehen. Das Modul 22 ist dabei eine Steuerungseinheit, über welche die Steuersignale 28 an den Roboter 10 geleitet werden. Die Steuereinheit 22 ist ferner mit der Computersteuerung 15 und mit einer Teaching-Einheit 21 verbunden, wobei Letztere eine Programmierung der Betätigungspositionen im Teach-in Verfahren erlaubt, während der Prüfablauf auf einem PC programmiert wird. Durch dieses Verfahren können auch komplizierte Aufgaben erledigt werden und zum Beispiel viele Bedienelemente nacheinander beziehungsweise im Wechsel betätigt werden. Auch Aufgabenstellungen wie zum Beispiel eine gezielt unkorrekte Betätigung mit ungleichmäßiger Belastung, die in der Praxis ebenfalls vorkommt, kann mit dem Roboter 10 erfüllt werden.

Das Datenerfassungsmodul 23 sammelt Messdaten 25 aus dem Inneren der Klimakammer 1 (zum Beispiel Spannung, Temperatur, Strom, DIO) und leitet diese an die PC-basierte Datenerfassung 20 weiter. Dabei kann insbesondere auch die gegenseitige Beeinflussung von Modulen beobachtet werden, wie sie zum Beispiel durch Entladeströme an Schnittstellen entsteht.

Schließlich ist noch ein Kraft-/Drehmomentverstärker 24 vorhanden, welcher die beim Betätigen der Bedienelemente auftretenden Reaktionen 27 wie insbesondere Schaltkräfte Fx, Fy, Fz sowie Schaltmomente Mx, My, Mz erfasst und nach Verstärkung an die Computersteuerung 15 weiterleitet. Kraft und Drehmoment werden so bei jeder Betätigung aufgezeichnet, die Messwerte werden protokolliert und in einer Statistik bereitgestellt.

Figur 3 zeigt eine typische Kraft-Weg-Beziehung bei der Betätigung eines Schalters. Auf der horizontalen Achse ist dabei die vom Schalter zurückgelegte Wegstrecke s in mm dargestellt, auf der vertikalen Achse die Kraft F in N. Derartige Kraft-Weg-Kurven (oder entsprechende Drehmoment-Winkel-Kurven) erlauben die Detektion von Änderungen der Schaltkräfte sowie der taktilen Rückkopplungskräfte für den Roboter. Die Kurve 30 stellt die maximale Betätigungskraft, die Kurve 31 die minimal erforderliche Betätigungskraft dar. Die Betätigungskraft 33 beträgt im Beispiel ca. 4 N. Der Kraftunterschied 32 von ca. 2,5 N entspricht der taktilen Rückkopplung.

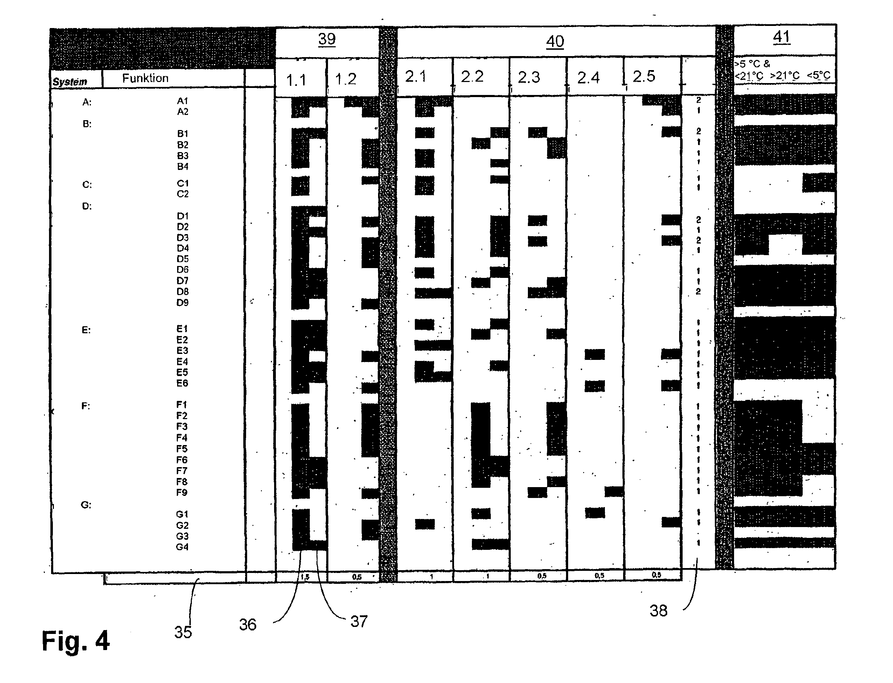

Figur 4 zeigt beispielhaft ein typisches Programm für die Betätigung von verschiedenen im Kraftfahrzeug vorhandenen Schaltern bzw. Bedienelementen. Für den Funktionstest werden verschiedene typische Bedienabläufe simuliert, sog. Szenarien 1.1 bis 2.5. In der linken Spalte sind untereinander verschiedene zu testende Systeme A bis G mit unterschiedlichen Funktionen aufgeführt. Die Bedeutung der Systeme und Funktionen in dem beispielhaften Programmablauf ist:
- A:: Verschiedene Funktionen (1. Gruppe)
A1: Fahrertür (Wechsel offen - geschlossen)
A2: Zündung
- B:: Klimafunktionen:
B1: Heizungsgebläse (Stufe 2)
B2: Heizungsgebläse (Stufe 4)
B3: Klimatisierung
B4: Umluft
- C:: Sichtbarkeitsfunktionen
C1: Heizbares Rücklicht
C2: Heizbare Heckscheibe
- D:: Externe Beleuchtung und Blinker
D1: Standlicht usw. bis
D9: Warnblinkanlage
- E:: Scheibenwischerfunktionen
E1: Frontwischer (Stufe 1) usw. bis
E6: Heckscheibenwischer (Intervallbetrieb)
- F:: Komfortfunktionen
F1: Elektrische Fensterheber auf -ab (Fahrer) usw. bis
F6: Schiebedachneigung

- G:: Verschiedene Funktionen (2. Gruppe)
G1: Zigarettenanzünder
G2: Instrumentenbrettdimmer (hell-dunkel)
G3: Hupe
In den verschiedenen Szenarien 1.1 bis 2.5 werden die jeweiligen Funktionen entweder eingeschaltet (schwarzer Balken im mittleren Bereich 36 der jeweiligen Spalte) oder ausgeschaltet (schwarzer Balken im rechten Bereich 37 der jeweiligen Spalte). Die Funktionen in der jeweiligen Spalte werden entweder in der Reihenfolge von oben nach unten (bei den Szenarien 1.1 sowie 2.1 bis 2.4) oder von unten nach oben (Szenarien 1.2 und 2.5) ausgeführt. In der untersten Zeile 35 ist die jeweilige ungefähre Betriebsdauer pro Bedienfunktion angegeben; in der Spalte 38 sind die Anzahl der Zyklen für die Ausführung der einzelnen Funktionen angegeben; durch eine zweifache Ausführung bestimmter Funktion wird die größere Häufigkeit der Bedienung der Funktionen in der Realität berücksichtigt. Die Szenarien 1.1 (sog. Start-Szenario) und 1.2 (sog. Stop-Szenario) stellen einen vollständigen Funktionstest dar, der über den gesamten Temperaturbereich durchgeführt wird. Bei den Szenarien 2.1 bis 2.5 werden bestimmte Funktionen in bestimmten Temperaturbereichen, in denen diese normalerweise nicht benötigt werden oder benutzt werden können, nicht ausgeführt, wie in Spalte 41 für die einzelnen Funktionen und drei exemplarische Temperaturbereiche jeweils angegeben (mittlerer Temperaturbereich >5°C und <21 °C, hoher Temperaturbereich >21 °C sowie niedriger Temperaturbereich < 5°C). Wie aus Figur 4 insgesamt ersichtlich, erlaubt das erfindungsgemäße Verfahren die Betätigung einer großen Anzahl verschiedener Funktionen nacheinander oder im Wechsel, so dass im Rahmen der Simulation auch komplexe Wechselwirkungen der einzelnen Bedienelemente untereinander erkannt werden können.

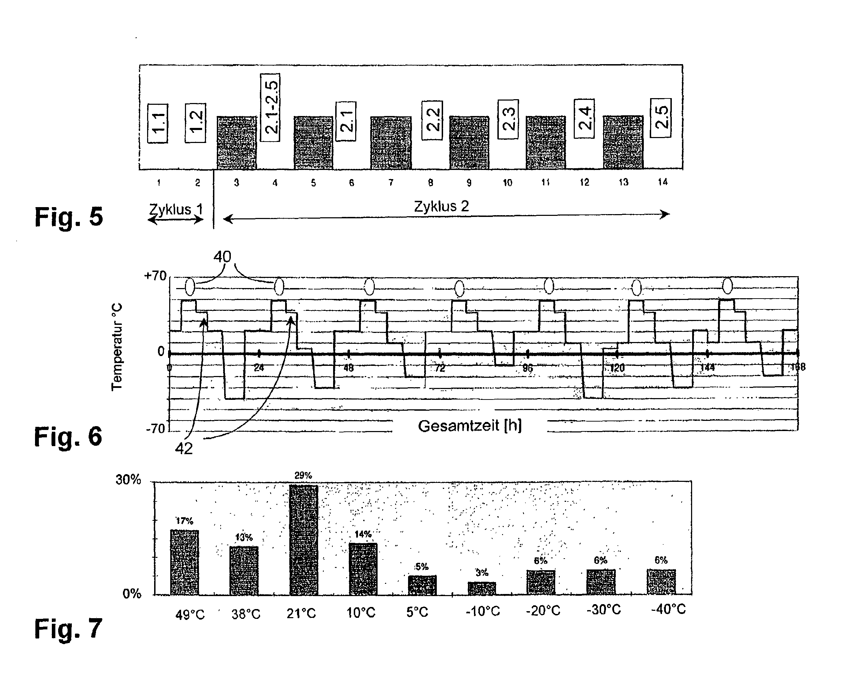

Figur 5 zeigt den Zeitablauf der Erzeugung von Vibrationen während eines Testzyklus. In zeitlicher Abfolge werden zunächst die Szenarien 1.1 und 1.2, und anschließend die Szenarien 2.1 bis 2.5 (vgl. Figur 4) ausgeführt. Bei einem zweiten Durchlauf der Szenarien 2.1 bis 2.5 wird jeweils zwischen den Szenarien eine Vibrationsphase (dunkler Bereich) ausgeführt.

Die Figuren 6 und 7 zeigen den während eines siebentägigen Tests eingestellten Temperaturverlauf sowie die prozentuale Häufigkeit der dabei auftretenden Temperaturen. Bei den mit dem Symbol 40 gekennzeichneten höchsten Temperaturen (50 °C) wird zusätzlich Sonnenbestrahlung simuliert. Bei dem mit 42 gekennzeichneten Temperaturniveau von 40° wird eine relative Luftfeuchtigkeit von 95 % eingestellt.

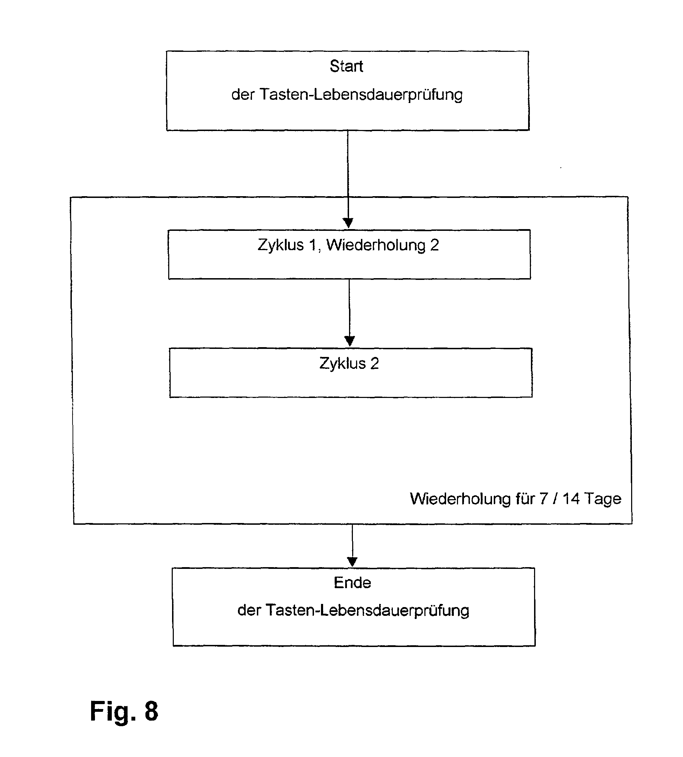

In Figur 8 ist ein vereinfachtes Ablaufdiagramm für eine siebentägige beziehungsweise vierzehntägige Prüfungsprozedur dargestellt. Wie hieraus erkennbar ist, wird das in Figur 5 dargestellte Vibrationsprofil während der gesamten Versuchsdauer von 7/14 Tagen ständig wiederholt, wobei die Vibrationen etwa alle zwei Minuten unterbrochen werden, um die Schalterbetätigungen entsprechend den in Figur 4 aufgelisteten Szenarien auszuführen.

Durch das erfindungsgemäße Testprogramm, welches rund um die Uhr während der gesamten Versuchsdauer ausgeführt wird, kann die Belastung aus der gesamten Lebensdauer eines Kraftfahrzeugs (ca. 10 Jahren) in einen Belastungstest von ca. vier Wochen Dauer komprimiert werden. Dabei wird gleichzeitig eine hohe Realitätsnähe und aufgrund der Automatisierung eine hohe Reproduzierbarkeit der Ergebnisse und damit ein hohes Zuverlässigkeitsniveau der Ergebnisse erreicht.

## Patentansprüche

1. Verfahren zur Belastungsprüfung von elektrischen Systemen eines Kraftfahrzeugs, wobei die Bedienelemente der Systeme durch mindestens eine automatische Betätigungsvorrichtung testweise betätigt werden,
**dadurch gekennzeichnet, dass** die elektrischen Systeme im eingebauten Zustand im Kraftfahrzeug (3) geprüft werden, und dass das Kraftfahrzeug während der Prüfung einer Simulation von realen Umgebungsbedingungen ausgesetzt ist.

2. Verfahren nach Anspruch 1,
**dadurch gekennzeichnet, dass** zu den Umgebungsbedingungen die Umgebungstemperatur gehört, welche während der Prüfung vorzugsweise zwischen -40°C und +85°C variiert wird.

3. Verfahren nach einem der Ansprüche 1 oder 2,
**dadurch gekennzeichnet, dass** zu den Umgebungsbedingungen die Luftfeuchtigkeit gehört.

4. Verfahren nach mindestens einem der Ansprüche 1 bis 3,
**dadurch gekennzeichnet, dass** zu den Umgebungsbedingungen die Sonneneinstrahlung gehört, welche vorzugsweise durch eine Bestrahlung mit einer Leistung von bis zu 5000 W/m² simuliert wird.

5. Verfahren nach mindestens einem der Ansprüche 1 bis 4,
**dadurch gekennzeichnet, dass** zu den Umgebungsbedingungen Beschleunigungen des Kraftfahrzeugs (3) gehören, welche vorzugsweise durch voneinander unabhängige vertikale Bewegungen der Standflächen (4a, 4b) der Räder des Kraftfahrzeugs simuliert werden.

6. Verfahren nach mindestens einem der Ansprüche 1 bis 5,
**dadurch gekennzeichnet, dass** die Betätigungsvorrichtung ein Roboter (10) ist.

7. Verfahren nach mindestens einem der Ansprüche 1 bis 6,
**dadurch gekennzeichnet, dass** die Betätigungsvorrichtung (10) die Kräfte und Momente beim Betätigen der Bedienelemente sensorisch erfasst.

8. Verfahren nach mindestens einem der Ansprüche 1 bis 7,
**dadurch gekennzeichnet, dass** die Betätigungsvorrichtung (10) die Kräfte und Momente bei der Betätigung der Bedienelemente variiert.

9. Vorrichtung zur Belastungsprüfung von elektrischen Systemen eines Kraftfahrzeugs, enthaltend mindestens eine automatische Bedienvorrichtung zur Betätigung der Bedienelemente der Systeme,
**dadurch gekennzeichnet, dass** die Vorrichtung zur Aufnahme eines die zu prüfenden Systeme enthaltenden Kraftfahrzeugs (3) eine Simulationskammer (1) aufweist, in der Umgebungsbedingungen simuliert werden können, und dass die automatische Betätigungsvorrichtung (10) innerhalb des Kraftfahrzeugs angeordnet werden kann.

10. Vorrichtung nach Anspruch 9,
**dadurch gekennzeichnet, dass** die Simulationskammer (1) eine Klimaanlage (8) aufweist.

11. Vorrichtung nach einem der Ansprüche 9 oder 10,
**dadurch gekennzeichnet, dass** die Simulationskammer (1) Strahler (2) zur Simulation von Sonneneinstrahlung aufweist.

12. Vorrichtung nach mindestens einem der Ansprüche 9 bis 11,
**dadurch gekennzeichnet, dass** die Simulationskammer (1) Standflächen (4a, 4b) für die Räder eines Kraftfahrzeugs (3) aufweist, die über eine Ansteuerung (7) separat vertikal bewegbar sind.

13. Vorrichtung nach mindestens einem der Ansprüche 9 bis 12,
**dadurch gekennzeichnet, dass** die Betätigungsvorrichtung Sensoren zur Erfassung von Kräften und Momenten bei der Betätigung von Bedienelementen der elektrischen Systeme aufweist.

14. Vorrichtung nach mindestens einem der Ansprüche 9 bis 13,
**dadurch gekennzeichnet, dass** die Betätigungsvorrichtung ein Roboter (10) ist.

15. Vorrichtung nach Anspruch 13,
**dadurch gekennzeichnet, dass** der Roboter (10) eine klimatisierbare Schutzumhüllung aufweist.

## Claims

1. Method for load testing electrical systems of a motor vehicle, the operator control elements of the systems being activated on a test basis by means of at least one automatic activation device, **characterized in that** the electrical systems are tested in the installed state in the motor vehicle (3), and **characterized in that** the motor vehicle is exposed to a simulation of real ambient conditions during the testing.

2. Method according to Claim 1, **characterized in that** the ambient conditions include the ambient temperature which is preferably varied between - 40°C and +85°C during the testing.

3. Method according to either of Claims 1 and 2, **characterized in that** the ambient conditions include the atmospheric humidity.

4. Method according to at least one of Claims 1 to 3, **characterized in that** the ambient conditions include the solar radiation which is preferably simulated by irradiation with a power of up to 5 000 W/m².

5. Method according to at least one of Claims 1 to 4, **characterized in that** the ambient conditions include acceleration events of the motor vehicle (3), which are preferably simulated by mutually independent vertical movements of the contact faces (4a, 4b) of the wheels of the motor vehicle.

6. Method according to at least one of Claims 1 to 5, **characterized in that** the activation device is a robot (10).

7. Method according to at least one of Claims 1 to 6, **characterized in that** the activation device (10) senses the forces and moments by sensor means when the operator control elements are activated.

8. Method according to at least one of Claims 1 to 7, **characterized in that** the activation device (10) varies the forces and moments when the operator control elements are activated.

9. Device for load testing electrical systems for a motor vehicle, containing at least one automatic operator control device for activating the operator control elements of the systems, **characterized in that** the device for accommodating a motor vehicle (3) which contains the systems to be tested has a simulation chamber (1) in which ambient conditions can be simulated, and
**characterized in that** the automatic activation device (10) can be arranged inside the motor vehicle.

10. Device according to Claim 9, **characterized in that** the simulation chamber (1) has an air-conditioning system (8).

11. Device according to either of Claims 9 and 10, **characterized in that** the simulation chamber (1) has radiators (2) for simulating solar radiation.

12. Device according to at least one of Claims 9 to 11, **characterized in that** the simulation chamber (1) has contact faces (4a, 4b) for the wheels of a motor vehicle (3) which can be moved separately in a vertical direction using an actuation means (7).

13. Device according to at least one of Claims 9 to 12, **characterized in that** the activation device has sensors for sensing forces and moments when operator control elements of the electrical systems are activated.

14. Device according to at least one of Claims 9 to 13, **characterized in that** the activation device is a robot (10).

15. Device according to Claim 13, **characterized in that** the robot (10) has a protective sleeve which can be air-conditioned.

## Revendications

1. Procédé d'essai d'endurance de systèmes électriques d'un véhicule automobile, dans lequel les éléments de commande des systèmes sont actionnés en mode de test par au moins un dispositif d'actionnement automatique, **caractérisé en ce que** les systèmes électriques sont contrôlés en position montée dans le véhicule automobile (3), et **en ce que** le véhicule automobile est soumis pendant l'essai à une simulation de conditions ambiantes réelles.

2. Procédé selon la revendication 1, **caractérisé en ce que** les conditions ambiantes comprennent la température ambiante, que l'on fait varier pendant l'essai de préférence entre -40°C et +85°C.

3. Procédé selon l'une quelconque des revendications 1 ou 2, **caractérisé en ce que** les conditions ambiantes comprennent l'humidité de l'air.

4. Procédé selon au moins une des revendications 1 à 3, **caractérisé en ce que** les conditions ambiantes comprennent le rayonnement solaire, qui est simulé de préférence par un rayonnement d'une puissance allant jusque 5000 W/m².

5. Procédé selon au moins une des revendications 1 à 4, **caractérisé en ce que** les conditions ambiantes comprennent des accélérations du véhicule automobile (3), qui sont simulées de préférence par des mouvements verticaux, indépendants les uns des autres, des surfaces d'appui (4a, 4b) des roues du véhicule automobile.

6. Procédé selon au moins une des revendications 1 à 5, **caractérisé en ce que** le dispositif d'actionnement est un robot (10).

7. Procédé selon au moins une des revendications 1 à 6, **caractérisé en ce que** le dispositif d'actionnement (10) détecte par des capteurs les forces et les couples lors de l'actionnement des éléments de commande.

8. Procédé selon au moins une des revendications 1 à 7, **caractérisé en ce que** le dispositif d'actionnement (10) fait varier les forces et les couples lors de l'actionnement des éléments de commande.

9. Dispositif d'essai d'endurance de systèmes électriques d'un véhicule automobile, comportant au moins un dispositif de commande automatique pour actionner les éléments de commande des systèmes, **caractérisé en ce que** le dispositif destiné à recevoir un véhicule automobile (3) contenant les systèmes à contrôler comprend une chambre de simulation (1), dans laquelle on peut simuler des conditions ambiantes, et **en ce que** le dispositif d'actionnement automatique (10) peut être disposé à l'intérieur du véhicule automobile.

10. Dispositif selon la revendication 9,
**caractérisé en ce que** la chambre de simulation (1) comporte une installation de climatisation (8).

11. Dispositif selon l'une quelconque des revendications 9 ou 10, **caractérisé en ce que** la chambre de simulation (1) comprend des radiateurs (2) pour simuler le rayonnement solaire.

12. Dispositif selon au moins une des revendications 9 à 11, **caractérisé en ce que** la chambre de simulation (1) comprend des surfaces d'appui (4a, 4b) pour les roues d'un véhicule automobile (3), qui sont mobiles verticalement de manière séparée au moyen d'une commande (7).

13. Dispositif selon au moins une des revendications 9 à 12, **caractérisé en ce que** le dispositif d'actionnement comprend des capteurs pour détecter des forces et des couples lors de l'actionnement d'éléments de commande des systèmes électriques.

14. Dispositif selon au moins une des revendications 9 à 13, **caractérisé en ce que** le dispositif d'actionnement est un robot (10).

15. Dispositif selon la revendication 13, **caractérisé en ce que** le robot (10) comprend une enceinte de protection pouvant être climatisée.
